Europäisches Patentamt

European Patent Office

Office européen des brevets

(11) Veröffentlichungsnummer : **0 082 216**
**B1**

# (12) EUROPÄISCHE PATENTSCHRIFT

(45) Veröffentlichungstag der Patentschrift :
09.10.85

(51) Int. Cl.⁴ : **H 01 L 23/14, H 01 L 23/52,**
**H 01 L 23/56**

(21) Anmeldenummer : **81110713.5**

(22) Anmeldetag : **23.12.81**

---

(54) **Mehrschichtiges, keramisches Substrat für integrierte Halbleiterschaltungen mit mehreren Metallisierungsebenen.**

---

(43) Veröffentlichungstag der Anmeldung :
**29.06.83 Patentblatt 83/26**

(45) Bekanntmachung des Hinweises auf die Patenterteilung : **09.10.85 Patentblatt 85/41**

(84) Benannte Vertragsstaaten :
**DE FR GB**

(56) Entgegenhaltungen :
**EP-A- 0 026 807**
**ELECTRONIC DESIGN, Band 28, Nr. 1, Januar 1980,**
**Seiten 39-40, St. Rochelle Park (USA); "Multilayered-**
**ceramic packages multiply circuit densities 40**
**times".**

(73) Patentinhaber : **IBM DEUTSCHLAND GMBH**
**Pascalstrasse 100**
**D-7000 Stuttgart 80 (DE)**
**DE**
**International Business Machines Corporation**
**Old Orchard Road**
**Armonk, N.Y. 10504 (US)**
**FR GB**

(72) Erfinder : **Schettler, Helmut, Dipl.-Ing.**
**Jägerstrasse 23**
**D-7405 Dettenhausen (DE)**
Erfinder : **Stadler, Ewald**
**Taunusstrasse 48**
**D-7033 Herrenberg-Kuppingen (DE)**

(74) Vertreter : **Neuland, Johannes, Dipl.-Ing.**
**Schönaicher Strasse 220**
**D-7030 Böblingen (DE)**

---

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein mehrschichtiges, keramisches Substrat für integrierte Halbleiterschaltungen, mit mindestens zwei durch eine dünne Isolierschicht voneinander getrennten, metallisierten Leitungsebenen und mit nach Anschlußstiften führenden Leitungen in mindestens einer der Ebenen. Ein derartiges Substrat, bei dem mindestens eine dazu parallele Leitungsebene als Bezugsspannungsebene zur Herabsetzung der induktiven Kopplung zwischen Signalebenen vorgesehen ist, ist aus Electronic Design, Bd 28, No. 1, Jan 1980, S. 39-40 bekannt.

Bei der ständig zunehmenden Anzahl von auf einem Halbleiterschaltungsplättchen angebrachten Halbleiter-Bauelementen und Schaltkreisen, werden an die Substrate für die Aufnahme solcher Halbleiter-Schaltungsplättchen, kurz Chips genannt, immer höhere Anforderungen gestellt. Insbesondere bei den auf dem Substrat unterzubringenden, nach den Anschlußstiften führenden Signalleitungen, ergeben sich in zunehmendem Maße Schwierigkeiten, einmal durch die induktive Kopplung zwischen den Signalleitungen und durch die hohe kapazitive Belastung der Signalleitungen durch eine in nur sehr geringem Abstand durch eine dünne Isolierschicht getrennt angeordnete Bezugsspannungsebene, die als Metallisierung über alles ausgeführt ist. Das Problem wird am besten dadurch verständlich, daß man sich die dabei möglichen Abmessungen vor Augen führt.

Diese Signalleitungen haben beispielsweise eine Breite von 0,1 mm oder weniger, die Zwischenräume zwischen den Signalleitungen bewegen sich z. B. in einem Bereich zwischen 2,5 bis 0,1 mm und weniger und die Isolierschichtdicke kann beispielsweise mit 1 bis 2 μm angenommen werden. Unter diesen Bedingungen sind die Auswirkungen von induktiver Kopplung zwischen den Signalleitungen und kapazitiver Belastung durch die Bezugsspannungsebene nicht mehr vernachlässigbar.

Die der Erfindung zugrundeliegende Aufgabe besteht nun darin, diese induktive Kopplung zwischen den Signalleitungen und die kapazitive Belastung da, wo es möglich erscheint, weitgehend zu verringern, bzw. fast ganz zu beseitigen, wobei mögliche Kurzschlüsse zwischen der Bezugsspannungsebene und Signalleitungsebenen vermieden werden sollen.

Dies wird erfindungsgemäß bei einem mehrschichtigen, keramischen Substrat der eingangs genannten Art dadurch erreicht, daß in einer zu der die Signalleitungen enthaltenen Leitungsebene parallelen Leitungsebene, kurzgeschlossene Leiterschleifen vorgesehen sind, die dem Verlauf der Signalleitungen folgend, jeweils zu beiden Seiten der Signalleitungen verlaufende Zweige aufweisen, die an ihren beiden Enden leitend miteinander verbunden sind.

Vorzugsweise ist die Leiterschleifen aufweisende Metallisierungsebenen eine Bezugsspannungsebene. Ganz allgemein kann jedoch gesagt werden, daß die Erfindung darin besteht, eine Mehrzahl von Signalleitungsebenen vorzusehen, wobei jeweils zwischen zwei Signalebenen eine Bezugsspannungsebene mit den sich parallel zu den nach Anschlußstiften führenden Signalleitungen erstreckenden Kurzschlußschleifen vorgesehen ist.

Besonders vorteilhaft ist es, wenn eine Bezugsspannungsebene bzw. eine erste Bezugsspannungsebene unmittelbar auf dem Substrat selbst angeordnet ist. Es ist andererseits aber auch möglich, eine erste Signalebene unmittelbar auf dem Substrat anzuordnen.

Die Erfindung wird nunmehr anhand eines Ausführungsbeispiels in Verbindung mit den beigefügten Zeichnungen im einzelnen näher erläutert.

Dabei zeigt :

Figur 1 einen Ausschnitt aus einer Signalleitungsebene, und

Figur 2 einen Ausschnitt aus einer erfindungsgemäß ausgestalteten Bezugsspannungsebene.

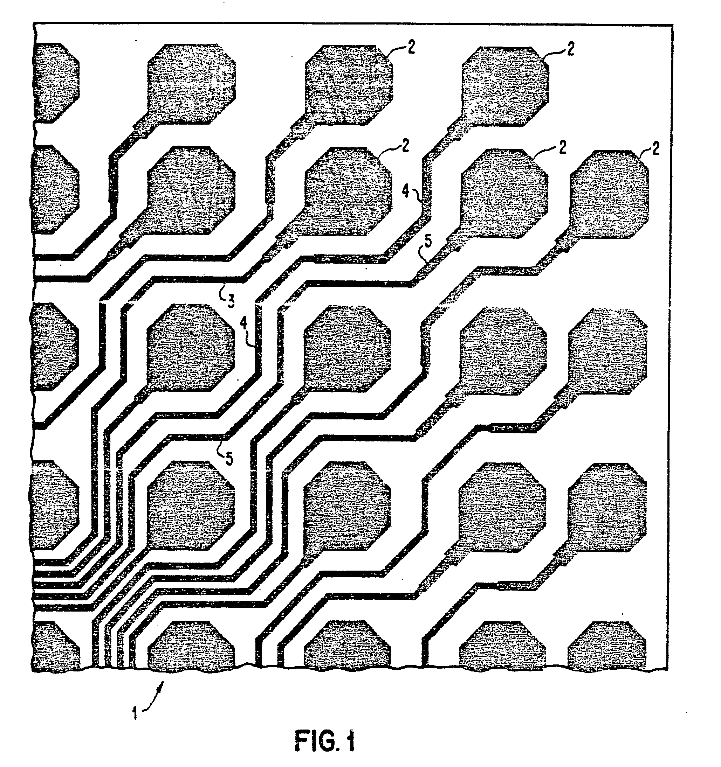

In Fig. 1 ist ein Ausschnitt aus einer Metallisierung einer Signalleitungsebene 1 gezeigt. Man erkennt dabei eine Anzahl von Lötstützpunkten 2, die im Verlaufe des Fertigungsverfahrens zum Anlöten von Anschlußstiften dienen. Diese Metallisierungsebene kann unmittelbar auf einem keramischen Substrat aufgebracht sein, und besteht normalerweise aus einer Schichtenfolge Chrom-Kupfer-Chrom. Die Stärke einer solchen Metallisierungsschicht beträgt üblicherweise etwa zwischen 4 und 8 μm. Man erkennt ferner eine Anzahl von Leitungszügen oder Signalleitungen 3, 4 und 5, die nach den Anschlußkontaktflächen 2 führen. Weitere Leitungszüge, die jedoch nicht bezeichnet sind, sind erkennbar.

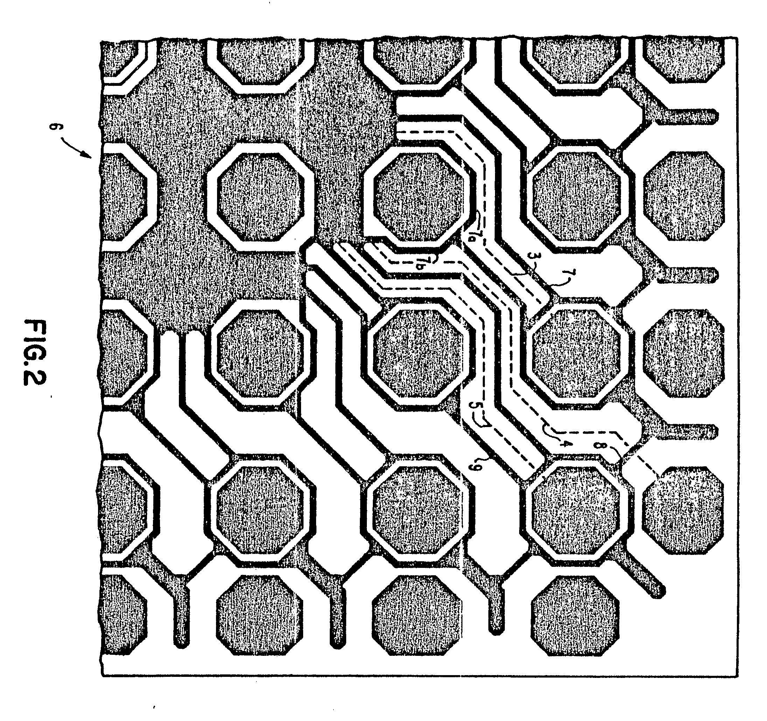

Von dieser ersten Metallisierungsschicht durch eine dünne Isolierschicht, die vorzugsweise aus Polyimid besteht, getrennt, ist eine zweite Metallisierungsschicht 6 vorgesehen. Diese zweite Metallisierungsschicht 6 ist in Fig. 2 dargestellt. In denjenigen Bereichen, in denen die erfindungsgemäße Ausgestaltung nicht durchführbar ist, ist diese Metallisierungsebene voll ausgeführt. Man erkennt jedoch, drei Kurzschlußschleifen 7, 8 und 9, die so ausgestaltet sind, daß sie die den in der Metallisierungsebene 1 liegenden Signalleitungen 3, 4 bzw. 5 in der Weise folgen, daß sie im wesentlichen zu beiden Seiten dieser Leitungszüge verlaufen und an ihren beiden Enden kurzgeschlossen sind. Man erkennt dabei, daß insbesondere die Kurzschlußschleife 7 sich einmal verzweigt in einen Zweig 7a und einen Zweig 7b, die beide jedoch nach der vollen Metallisierung führen und damit dort kurzgeschlossen sind. Man erkennt ferner in der zweiten Metallisierungsebene die innenliegenden achteckigen Metallisierungsfelder der ersten Ebene und dazwischendrin eine entsprechende achteckige Isolierzone aus dem Isoliermaterial der Isolierschicht.

Es ist jedoch besonders vorteilhaft, wenn die zweite Metallisierungsschicht, die eine Bezugsspannungsebene darstellt, unmittelbar auf dem Substrat liegt und von einer Isolierschicht aus vorzugsweise Polyimid überdeckt ist, da sich dadurch eine wesentlich glattere Oberfläche für die zweite Metallisierungsebene mit den Signalleitungen ergibt.

In diesem Zusammenhang sei darauf hingewiesen, daß das keramische Substrat eine der Anzahl der Anschlußkontaktflächen 2 entsprechende Anzahl von Bohrungen aufweist, in die später die Anschlußstifte eingesetzt werden sollen. Man kann sich nunmehr leicht vorstellen, daß die Anschlußstifte derartig in die durchgehenden Bohrungen eingesetzt werden, daß sie Kontakt mit den Anschlußkontaktflächen 2 bekommen, mit denen sie dann später verlötet werden. Dies ist in einer einfachen Ausführungsform, bei der die Bezugsmetallisierungsebene 6 unmittelbar auf dem Substrat angebracht ist, besonders günstig, da dann die Signalleitungen 3, 4, 5 der Signalleitungsebene 1 unmittelbar an die Metallisierung der Anschlußkontaktflächen 2 herangeführt werden können, die eine in der Mitte befindliche durchgehende Bohrung enthalten, durch die dann die Anschlußkontaktstifte einsetzbar sind. Diese werden in an sich bekannter Technik an ihrem kopfseitigen Ende breitgequetscht und mit der Signalleitungsebene an den Anschlußkontaktflächen verlötet.

Dies hat nun die folgenden Vorteile :

Durch diese Kurzschlußschleifen wird insgesamt die Ausbeute bei der Herstellung im Vergleich mit einer durchgehenden Bezugsspannungsebene wesentlich verbessert. Während der Herstellung werden in die vorzugsweise aus Polyimid bestehende Isolierschicht Öffnungen eingeätzt. Staubteilchen auf der Maske für diese Öffnungen können außerdem zu Folge haben, daß in der Isolierschicht nicht gewünschte . Löcher geätzt werden, wodurch die zweite Metallisierungsschicht, wenn sie auf die Isolierschicht aufgebracht wird, in Kontaktberührung mit der ersten Metallisierungsschicht kommt und Kurzschlüsse verursacht. Eine durchgehende Bezugsspannungsebene kann daher Kurzschlüsse mit den Signalleitungen hervorrufen, die auf der Oberseite der Isolierschicht angeordnet werden.

Die Kurzschlußschleifen, die nunmehr in den Kanälen zwischen den Signalleitungen vorgesehen werden, können keine Kurzschlüsse hervorrufen. Diese Kurzschlußschleifen werden daher vor allem dort verwendet, wo der Zwischenraum zwischen den einzelnen Signalleitungen groß genug ist um in einer dazu parallelen Leitungsebene die Leitungen für die Kurzschlußschleifen unterzubringen.

Durch die Erfindung wird vor allem erreicht, daß das Übersprechen zwischen den Signalleitungen durch die Verringerung der induktiven Kopplung zwischen den Signalleitungen weitgehend vermieden wird. Weiterhin wird die kapazitive Belastung der Signalleitungen durch die darüberliegenden Teile der Metallisierung der Bezugsspannungsebene an der Stelle der Kurzschlußschleifen drastisch verringert. Dadurch erhält man eine höhere Impedanz der Signalleitungen und zwar durch die Verringerung der kapazitiven Belastung der Leitungen in bezug auf eine volle oder massive Bezugsspannungsebene.

Abschließend soll noch angeführt werden, daß die gleiche Konstruktion auch mit einer größeren Anzahl von Bezugsleitungsebenen und dazwischen isoliert angeordneten Signalleitungsebenen möglich ist. Da im allgemeinen an der Peripherie derartiger Metallisierungen die Abstände zwischen den Signalleitungen größer sind und da außerdem die Leitungsführungen für diese Signalleitungen oft ähnlich verlaufen, ist eine Anordnung mit mehreren Signalleitungsebenen und mit mehreren Bezugsspannungsebenen denkbar und befindet sich auch bereits in der Entwicklung.

Insgesamt kann zusammenfassend gesagt werden, daß durch die Erfindung ein schwieriges Problem bei Substraten für hochintegrierte Halbleiterschaltungsplättchen in überraschend einfacher Weise gelöst werden konnte.

## Patentansprüche

1. Mehrschichtiges keramisches Substrat für integrierte Halbleiterschaltungen mit mindestens zwei durch eine Isolierschicht voneinander getrennten metallisierten Leitungsebenen und mit nach Anschlußstiften führenden Leitungen in mindestens einer der Ebenen, dadurch gekennzeichnet, daß in mindestens einer dazu parallelen Leitungsebene (6) kurzgeschlossene Leiterschleifen (7, 8, 9) vorgesehen sind, die dem Verlauf der Signalleitungen (3, 4, 5) folgend, jeweils zu beiden Seiten der Signalleitungen verlaufende Zweige aufweisen, die an beiden Enden miteinander verbunden sind.

2. Substrat nach Anspruch 1, dadurch gekennzeichnet, daß die Leiterschleifern aufweisende Metallisierungsebene eine Bezugsspannungsbene (6) ist.

3. Substrat nach Anspruch 1, dadurch gekennzeichnet, daß eine Mehrzahl von Signalleitungsebenen (1) vorgesehen ist und daß jeweils zwischen zwei Signalebenen eine Bezugsspannungsebene mit den sich parallel zu den nach Anschlußstiften führenden Signalleitungen erstreckenden Kurzschlußschleifen angeordnet ist.

4. Substrat nach einem der Ansprüche 1 bis 3, dadurch gekennzeichnet, daß eine Bezugsspannungsebene unmittelbar auf dem Substrat angeordnet ist.

5. Substrat nach Anspruch 1 und 2, dadurch gekennzeichnet, daß die Bezugsspannungsebene zwischen zwei durch Isolierschichten davon isolierte Signalleitungsebenen angeordnet ist.

## Claims

1. Multilayer ceramic substrate for integrated semiconductor circuits with at least two metallized conducting planes separated by an insulating layer, and with conductors to contact pins in at least one of the planes, characterized in that in at least one conducting plane (6) parallel thereto shorted loops (7, 8, 9) are provided which following the course of the signal conductors (3, 4, 5) have branches which extend on both sides of the signal conductors, and are interconnected at both ends.

2. Substrate as claimed in claim 1, characterized in that the metallization plane with conductor loops is a reference voltage plane (6).

3. Substrate as claimed in claim 1, characterized in that a plurality of signal planes (1) is provided, and that between two respective signal planes one reference voltage plane is provided, with the shorted loops extending in parallel to the signal conductors toward the contact pins.

4. Substrate as claimed in any one of claims 1 to 3, characterized in that a reference voltage plane is arranged directly on the substrate.

5. Substrate as claimed in claims 1 and 2, characterized in that the reference voltage plane is arranged between two signal planes insulated therefrom by insulating layers.

**Revendications**

1. Substrat céramique multicouche pour circuits semiconducteurs intégrés, comportant au moins deux plans de conduction métallisés, séparés l'un de l'autre par une couche isolante mince, et des conducteurs aboutissant à des fiches de connexion dans au moins un des plans, caractérisé en ce qu'il est prévu dans au moins un plan de conduction (6) parallèle des boucles conductrices court-circuitées (7, 8, 9) qui, en suivant le profil des conducteurs de transmission de signaux (3, 4, 5) comportent respectivement des branches disposées des deux côtés des conducteurs de transmission de signaux et qui sont reliées entre elles aux deux extrémités.

2. Substrat selon la revendication 1, caractérisé en ce que le plan de métallisation comportant les boucles conductrices est un plan de tension de référence (6).

3. Substrat selon la revendication 1, caractérisé en ce qu'il est prévu plusieurs plans de conduction de signaux (1) et en ce que respectivement entre deux plans de conduction de signaux est disposé un plan de tension de référence avec des boucles de court-circuit s'étendant parallèlement aux conducteurs de transmission de signaux aboutissant à des fiches de connexion.

4. Substrat selon une des revendications 1 à 3, caractérisé en ce qu'un plan de tension de référence est placé directement sur le substrat.

5. Substrat selon une des revendications 1 et 2, caractérisé en ce que le plan de tension de référence est disposé entre deux plans de conduction de signaux isolés de celui-ci par des couches isolantes.

FIG. 1

FIG.2